(19) **Europäisches Patentamt**

**European Patent Office**

**Office européen des brevets**

(11) **EP 1 662 588 A1**

(12) **EUROPEAN PATENT APPLICATION**
published in accordance with Art. 158(3) EPC

(43) Date of publication:
**31.05.2006 Bulletin 2006/22**

(51) Int Cl.:
*H01L 35/32* (1974.07)    *H01L 35/30* (1974.07)
*H01L 35/34* (1974.07)

(21) Application number: **03817992.5**

(22) Date of filing: **08.08.2003**

(86) International application number:
**PCT/JP2003/010182**

(87) International publication number:
**WO 2005/015649 (17.02.2005 Gazette 2005/07)**

(84) Designated Contracting States:
**AT BE BG CH CY CZ DE DK EE ES FI FR GB GR HU IE IT LI LU MC NL PT RO SE SI SK TR**

(71) Applicant: **NAGAMINE MANUFACTURING CO., LTD.**
**Nakatado-gun, Kagawa 766-0026 (JP)**

(72) Inventor: **NAGAMINE, Masaru**
**Nakatado-gun, Kagawa 766-0021 (JP)**

(74) Representative: **Wagner, Karl H.**
**Wagner & Geyer**
**Gewürzmühlenstrasse 5**
**80539 München (DE)**

(54) **THERMOELECTRIC CONVERSION ELEMENT AND PRODUCTION METHOD THEREFOR**

(57)    An object of the present invention is to provide a thermoelectric-conversion element whose physical strength is high, whose generating capacity is large, whose probability of being damaged during its manufacturing process is low, and whose manufacture requires a relatively small number of man-hours. Another object of the present invention is to provide a method of manufacturing the thermoelectric-conversion element.

A thermoelectric-conversion element 1 comprising (i) an n-type member 10 which includes a conductive tubular member 11 having a channel 11h in it and an n-type semiconductive layer 12 formed on the outside of the conductive tubular member 11, (ii) a p-type member 20 which includes a conductive tubular member 21 having a channel 21h in it and a p-type semiconductive layer 22 formed on the outside of the conductive tubular member 21, and (iii) a connector 2 which electrically connects the conductive tubular member 11 of the n-type member 10 and the conductive tubular member 21 of the p-type member 20.

FIG. 1

**Description**

Technical Field

This invention relates to a thermoelectric-conversion element and its manufacturing method.

Thermoelectric-conversion elements which make use of Seebeck effect have been attracting attention and developed as means for generating electricity by converting heat discharge from engines, incinerators, etc. into electricity.

The generating capacity $Z$ of such a thermoelectric-conversion element is given by the expression below:

$$Z = S^2\sigma \Big/ \kappa$$

where $S$ is the Seebeck coefficient; $\sigma$, electric conductivity (S/cm); $\kappa$, thermal conductivity (W/cm·k).

Accordingly, the generating capacity $Z$ of such a thermoelectric-conversion element can be raised by (i) raising the Seebeck coefficient $S$, (ii) shortening the path of electricity, and (iii) increasing the temperature difference between the hot and cold junctions.

The present invention relates to a thermoelectric-conversion element with a large generating capacity and its manufacturing method.

Background Art

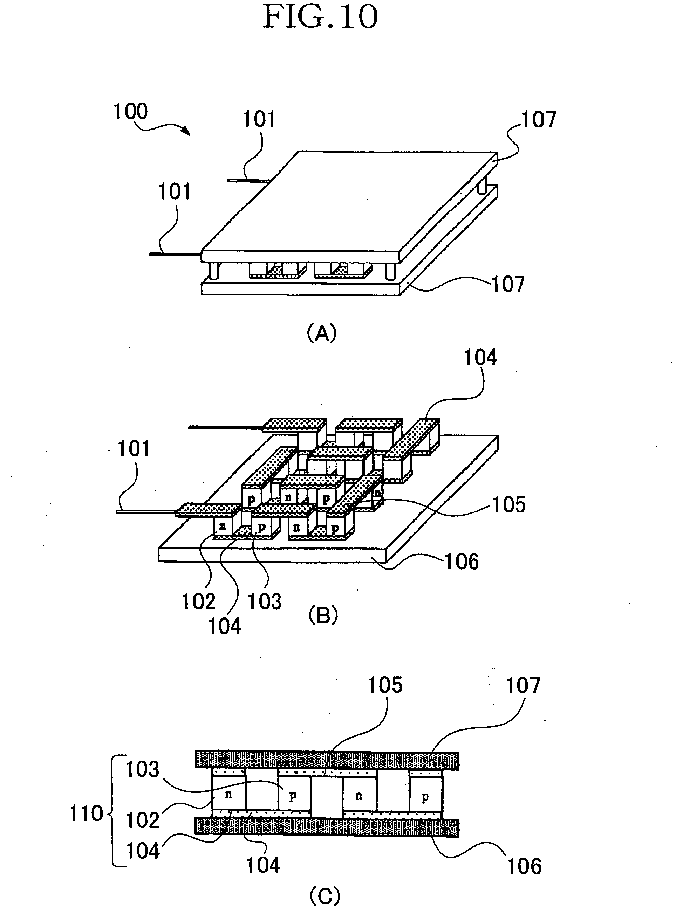

Fig. 10 shows a conventional thermoelectric-conversion module 100 comprising a plurality of thermoelectric-conversion elements 110. As shown in Fig. 10 (C), each thermoelectric-conversion element 110 comprises an n-type semiconductor 102, a p-type semiconductor 103, and conductors 104 and 105. When temperature difference occurs between the junctions of the semiconductors 102/103 and the conductor 104 and the junctions of the semiconductors 102/103 and the conductor 105, potential difference occurs between the former junctions and the latter junctions.

Because the electromotive force of one thermoelectric-conversion element 110 is small, a plurality of thermoelectric-conversion elements 110 are connected in series to form the thermoelectric-conversion module 100 as shown in Fig. 10 (B). The n-type and p-type semiconductors 102 and 103 of each thermoelectric-conversion element 110 are connected to the p-type semiconductor 103 of another thermoelectric-conversion element 110 and the n-type semiconductor 102 of yet another thermoelectric-conversion element 110, respectively. As shown in Fig. 10 (A), electric insulators 106 and 107 are put on the conductors 104 and 105. When one of the electric insulators 106 and 107 is heated or cooled, potential differences occur between the conductors 104 and the conductors 105. Accordingly, electric power can be extracted from the thermoelectric-conversion module 100 through electrodes 101 and 101 shown in Fig. 10 (B).

However, the n-type and p-type semiconductors 102 and 103 of the conventional thermoelectric-conversion module 100 have to be joined one by one to conductors 104 and 105 with solder, requiring many working steps and thereby making it difficult to put the thermoelectric-conversion module 100 to practical use.

Besides, the capacity of the thermoelectric-conversion element 110 is in proportion to the electric conductivity of the n-type and p-type semiconductors 102 and 103; therefore, if the thickness of the n-type and p-type semiconductors 102 and 103 is reduced to raise their conductivity, the generating capacity of the thermoelectric-conversion element 110 can be raised. However, it is difficult to manufacture thin semiconductors, whose strength is small; therefore, they are liable to be damaged when they are joined to conductors such as conductors 104 and 105 with solder.

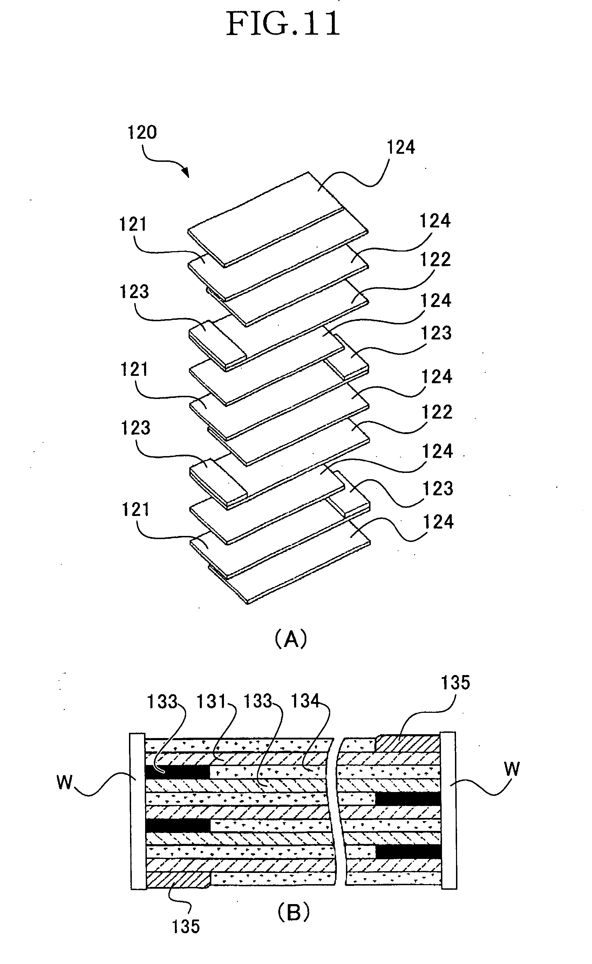

The Japanese Unexamined Patent Publication No. 1989-183863 addresses the above problems. Fig. 11 shows the thermoelectric-conversion element 130 of the prior art. Fig 11 (A) shows a stack 120 of thin-plate-like semicoriductive green bodies 121, thin-plate-like non-conductive green bodies 124 with thin-plate-like conductors 123, and thin-plate-like semiconductive green bodies 122. The stack 120 is sintered and, thereby, the semiconductors 131 and 132 and the insulators 134 are joined together. Thus, it is unnecessary to join the semiconductors 131 and 132 one by one to the conductors 133 with solder. On the other hand, a step of stacking thin-plate-like semiconductive green bodies 121, thin-plate-like non-conductive green bodies 124 with thin-plate-like conductors 123, and thin-plate-like semiconductive green bodies 122 is necessary. Therefore, the necessary man-hours can not be reduced very much.

Besides, the green bodies 121, 124, and 122 are thin and fragile and therefore are liable to be damaged when they are stacked.

Moreover, because electricity flows in a longitudinal direction of each of the thin-plate-like semiconductors 131 and 132, the path of electricity in each of the thin-plate-like semiconductors 131 and 132 is considerably long. Therefore, the electric conductivity of each of the thin-plate-like semiconductors 131 and 132 is considerably low and hence the generating capacity of the thermoelectric-conversion element 130 is low. If the paths of electricity in the thin-plate-like semiconductors 131 and 132 are shortened, the thickness of the thermoelectric-conversion element 130 (the distance between the electric insulators "W" and "W") is reduced. Thus, the strength of the thermoelectric-conversion element 130 is reduced, too.

As described above, the above prior art fails to give the thermoelectric-conversion element 130 both high physical strength and large generating capacity.

Disclosure of Invention

Accordingly, an object of the present invention is to provide a thermoelectric-conversion element whose physical strength is high, whose generating capacity is large, whose probability of being damaged during its manufacturing process is low, and whose manufacture requires a relatively small number of man-hours. Another object of the present invention is to provide a method of manufacturing the thermoelectric-conversion element.

According to the first feature of the present invention, there is provided a thermoelectric-conversion element comprising (i) an n-type member which includes a conductive tubular member having a channel in it and an n-type semiconductive layer formed on the outside of the conductive tubular member, (ii) a p-type member which includes a conductive tubular member having a channel in it and a p-type semiconductive layer formed on the outside of the conductive tubular member, and (iii) a connector which electrically connects the conductive tubular member of the n-type member and the conductive tubular member of the p-type member.

The advantage offered by the first feature of the present invention is as follows. When hot or cold fluid is run through the channels, temperature difference occurs between the hot and cold junctions of the n-type and p-type members and, hence, potential difference occurs between the hot and cold junctions of the n-type and p-type members. Accordingly, electric power can be extracted from the thermoelectric-conversion element. Besides, because hot or cold fluid is run through the channels, the conductive tubular members are efficiently heated or cooled; accordingly, large temperature difference is created between the hot and cold junctions and, hence, the generating capacity of the thermoelectric-conversion element is large. If the length of the n-type and p-type members is increased, the areas of the n-type and p-type semiconductive layers increase; therefore, the generating capacity of the thermoelectric-conversion element increases. Moreover, if the thickness of the n-type and p-type semiconductive layers is decreased, the paths of electricity in the n-type and p-type semiconductive layers are shortened and, hence, the electric conductivity of the n-type and p-type semiconductive layers increases; therefore, the generating capacity of the thermoelectric-conversion element increases. Furthermore, because the conductive tubular members bear the force working on the n-type and p-type semiconductive layers, the physical strength of the thermoelectric-conversion element is high.

According to the second feature of the present invention, there is provided a thermoelectric-conversion module comprising a plurality of thermoelectric-conversion elements according to the first feature connected in series. The n-type and p-type semiconductive layers of each thermoelectric-conversion element are connected to the p-type semiconductive layer of another thermoelectric-conversion element and the n-type semiconductive layer of yet another thermoelectric-conversion element, respectively.

The advantage offered by the second feature of the present invention is as follows. Because a plurality of thermoelectric-conversion elements are connected in series to form a module, a large electric power can be extracted from the module.

According to the third feature of the present invention, there is provided a thermoelectric-conversion element comprising (i) an n-type member which includes a conductive tubular member having a channel in it and an n-type semiconductive layer formed on the outside of the conductive tubular member, (ii) a p-type member which includes a conductive tubular member having a channel in it and a p-type semiconductive layer formed on the outside of the conductive tubular member, and (iii) a connector which electrically connects the n-type semiconductive layer and the p-type semiconductive layer.

The advantage offered by the third feature of the present invention is as follows. When hot or cold fluid is run through the channels, temperature difference occurs between the hot and cold junctions of the n-type and p-type members and, hence, potential difference occurs between the hot and cold junctions of the n-type and p-type members. Accordingly, electric power can be extracted from the thermoelectric-conversion element. Besides, because hot or cold fluid is run through the channels, the conductive tubular members are efficiently heated or cooled; accordingly, large temperature difference is created between the hot and cold junctions and, hence, the generating capacity of the thermoelectric-conversion element is large. If the length of the n-type and p-type members is increased, the areas of the n-type and p-type semiconductive layers increase; therefore, the generating capacity of the thermoelectric-conversion element increases. Moreover, if the thickness of the n-type and p-type semiconductive layers is decreased, the paths of electricity in the n-type and p-type semiconductive layers are shortened and, hence, the electric conductivity of the n-type and p-type semiconductive layers increases; therefore, the generating capacity of the thermoelectric-conversion element increases. Furthermore, because the conductive tubular members bear the force working on the n-type and p-type semiconductive layers, the physical strength of the thermoelectric-conversion element is high.

According to the fourth feature of the present invention, there is provided a thermoelectric-conversion module comprising a plurality of thermoelectric-conversion elements according to the third feature connected in series. The conductive tubular member of the n-type member and the conductive tubular member of the p-type member of each thermoelectric-conversion element are connected to the conductive tubular member of the p-type member of another thermoelectric-conversion element and the conductive tubular member of the n-type member of yet another thermoelectric-conversion element, respectively.

The advantage offered by the fourth feature of the present invention is as follows. Because a plurality of thermoelectric-conversion elements are connected in series to form a module, a large electric power can be extracted from the module.

According to the fifth feature of the present invention, there is provided the thermoelectric-conversion element according to the first, second, third, or fourth feature, wherein a conductive layer is formed on each of the n-type and p-type semiconductive layers.

The advantage offered by the fifth feature of the present invention is as follows. Because electricity flows perpendicularly to the longitudinal center axis of the conductive tubular member of each of the n-type and p-type members, the paths of electricity in the n-type and p-type semiconductive layers are short. Besides, because the conductive layers bear the force working on the n-type and p-type semiconductive layers, the physical strength of the thermoelectric-conversion element is large.

According to the sixth feature of the present invention, there is provided a thermoelectric-conversion element comprising (i) a conductive tubular member having a channel in it, (ii) an n-type semiconductive layer formed on one half of the outer surface of the conductive tubular member when the outer surface is divided into two along the longitudinal center axis of the conductive tubular member, and (iii) a p-type semiconductive layer formed on the other half of the outer surface of the conductive tubular member. The n-type and p-type semiconductive layers are connected by the conductive tubular member.

The advantage offered by the sixth feature of the present invention is as follows. When hot or cold fluid is run through the channel, temperature difference occurs between the hot and cold junctions and, hence, potential difference occurs between the hot and cold junctions. Accordingly, electric power can be extracted from the thermoelectric-conversion element. Besides, because hot or cold fluid is run through the channel, the conductive tubular member is efficiently heated or cooled; accordingly, large temperature difference is created between the hot and cold junctions and, hence, the generating capacity of the thermoelectric-conversion element is large. If the length of the conductive tubular member and the n-type and p-type semiconductive layers is increased, the areas of the n-type and p-type semiconductive layers increase; therefore, the generating capacity of the thermoelectric-conversion element increases. Moreover, if the thickness of the n-type and p-type semiconductive layers is decreased, the paths of electricity in the n-type and p-type semiconductive layers are shortened and, hence, the electric conductivity of the n-type and p-type semiconductive layers increases; therefore, the generating capacity of the thermoelectric-conversion element increases. Furthermore, because the conductive tubular member bears the force working on the n-type and p-type semiconductive layers, the physical strength of the thermoelectric-conversion element is high.

According to the seventh feature of the present invention, there is provided a thermoelectric-conversion module comprising a plurality of thermoelectric-conversion elements according to the sixth feature connected in series. The n-type and p-type semiconductive layers of each thermoelectric-conversion element are connected to the p-type semiconductive layer of another thermoelectric-conversion element and the n-type semiconductive layer of yet another thermoelectric-conversion element, respectively.

The advantage offered by the seventh feature of the present invention is as follows. Because a plurality of thermoelectric-conversion elements are connected in series to form a module, a large electric power can be extracted from the module.

According to the eighth feature of the present invention, there is provided a method of manufacturing a thermoelectric-conversion element, comprising the steps of (i) forming an n-type body including a conductive tubular member having a channel in it and an n-type semiconductive layer formed on the outside of the conductive tubular member and a p-type body including a conductive tubular member having a channel in it and a p-type semiconductive layer formed on the outside of the conductive tubular member, (ii) sintering the n-type and p-type bodies, and (iii) connecting the n-type and p-type bodies in series by a conductor.

The advantage offered by the eighth feature of the present invention is as follows. Just by sintering each of the n-type and p-type bodies, the conductive tubular member and the semiconductive layer are made as a single unit, requiring no particular step of joining them together. Thus, the number of steps of the process of making the thermoelectric-conversion element is held down.

According to the ninth feature of the present invention, there is provided the method according to the eighth feature, wherein a conductive layer is formed on the semiconductive layer of each of the sintered n-type and p-type bodies before the sintered n-type and p-type bodies are connected in series by a conductor.

The advantage offered by the ninth feature of the present invention is as follows. Because electricity flows perpendicularly to the longitudinal center axis of the conductive tubular member of each of the n-type and p-type bodies, the paths of electricity in the n-type and p-type semiconductive layers are short. Besides, because the conductive layers bear the force working on the n-type and p-type semiconductive layers, the physical strength of the thermoelectric-conversion element is large.

According to the tenth feature of the present invention, there is provided the method according to the eighth or ninth feature, wherein each of the n-type and p-type bodies is formed by extruding a conductive tubular member and a fluid semiconductive material simultaneously from a single die.

The advantage offered by the tenth feature of the present invention is as follows. Because the semiconductive layer of each of the n-type and p-type bodies is formed on the outside of the conductive tubular member of said body, the semiconductive layer is supported by the conductive tubular member; accordingly, if the semiconductive layer is relatively thin, it is prevented from breaking while it is being formed. Thus, the thermoelectric-conversion element is manufactured efficiently.

According to the eleventh feature of the present invention, there is provided the method according to the eighth of ninth feature, wherein each of the n-type and p-type bodies is formed by extruding a fluid conductive material and a fluid semiconductive material simultaneously from a single die.

The advantage offered by the eleventh feature of the present invention is as follows. Because both the conductive tubular member and the semiconductive layer of each of the n-type and p-type bodies are formed out of fluid materials, the n-type and p-type bodies can be given various shapes. Thus, the thermoelectric-conversion element can be given various shapes.

Brief Description of Drawings

Fig. 1 is a schematic perspective view of an embodiment of thermoelectric-conversion module of the present invention.

Fig. 2 is a schematic front view of the thermoelectric-conversion module of Fig. 1.

Fig. 3 (A) is a schematic front view of another embodiment of thermoelectric-conversion element of the present invention. Fig. 3 (B) is a schematic front view of a thermoelectric-conversion module including two units of the thermoelectric-conversion element of Fig. 3 (A).

Fig. 4 (A) is a schematic front view of yet another embodiment of thermoelectric-conversion element of the present invention. Fig. 4 (B) is a schematic front view of a thermoelectric-conversion module including two units of the thermoelectric-conversion element of Fig. 4 (A).

Fig. 5 (A) is an illustration of a conductive tubular member-cum-semiconductive layer in process. Fig. 5 (B) is a flowchart of making the n-type and p-type members of Figs. 1 and 2 out of the conductive tubular member-cum-semiconductive layer in process of Fig. 5 (A).

Fig. 6 is a schematic illustration of a die to form the conductive tubular member-cum-semiconductive layer of Fig. 5 (A).

Fig. 7 is a schematic illustration of a die to form another conductive tubular member-cum-semiconductive layer, out of which the thermoelectric-conversion element of Fig. 4 (A) is made.

Fig. 8 is a schematic illustration of a die to form yet another conductive tubular member-cum-semiconductive layer in accordance with the present invention.

Fig. 9 is a schematic illustration of a die to form a further conductive tubular member-cum-semiconductive layer in accordance with the present invention.

Fig. 10 is a schematic illustration of a thermoelectric-conversion module according to prior art.

Fig. 11 is a schematic illustration of a thermoelectric-conversion element according to prior art.

Best Mode for carrying out the Invention

By referring to the drawings, a preferred embodiment of thermoelectric-conversion element of the present invention will be described below.

The thermoelectric-conversion element of the present invention converts thermal energy into electric energy through Seebeck effect. The electricity-generating efficiency of the thermoelectric-conversion element is raised by providing channels through which cooling or heating fluid flows. Besides, the manufacturing efficiency of the thermoelectric-conversion element and modules each of which comprises a plurality of thermoelectric-conversion elements of the present invention is high.

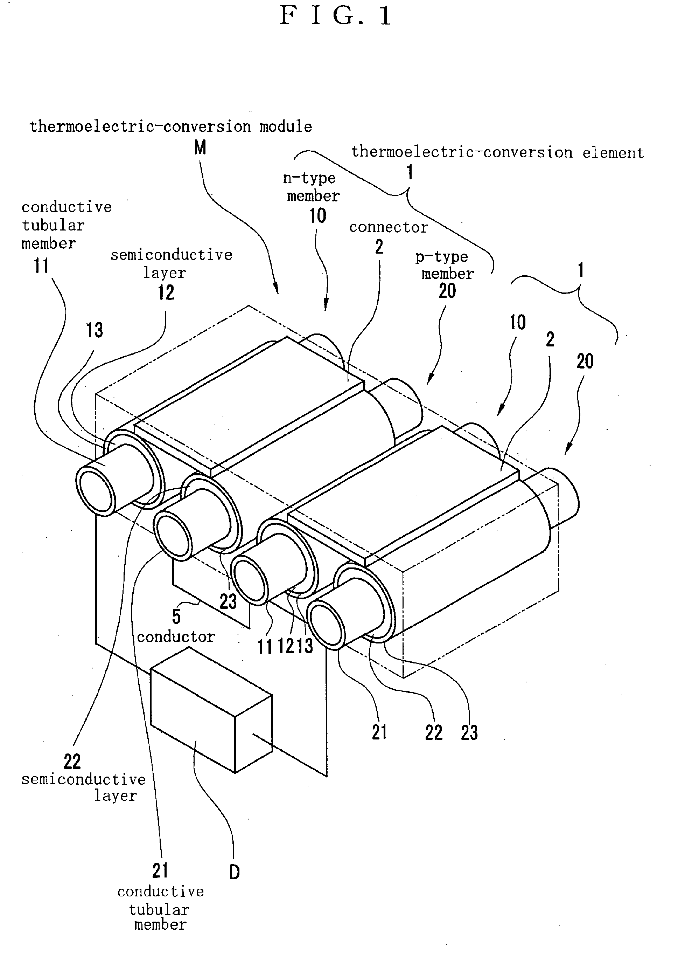

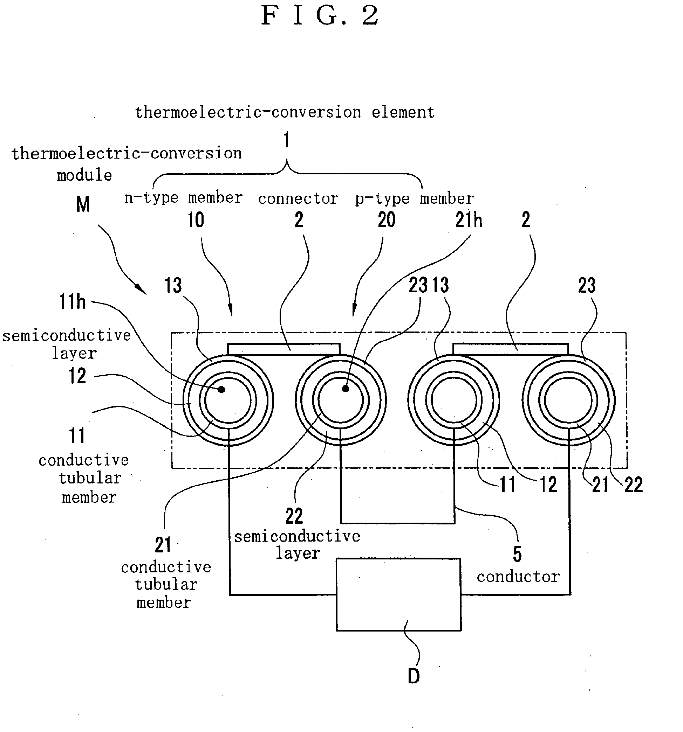

Fig. 1 is a schematic perspective view of a thermoelectric-conversion module "M" which comprises two thermoelectric-conversion elements 1 and 1 of the present invention. Fig. 2 is a schematic front view of the thermoelectric-conversion module "M" of Fig. 1. In Figs. 1 and 2, the reference numeral 10 is an n-type member of a thermoelectric-conversion element 1. The n-type member 10 comprises a conductive tubular member 11, an n-type semiconductive layer 12, and a conductive layer 13. The cross section of the conductive tubular member 11 is circular. The reference sign 11h is a channel which is a through hole made in the conductive tubular member 11 and through which fluid flows. The n-type semiconductive layer 12 is formed on the outside of the conductive tubular member 11. The conductive layer 13 is formed on the n-type semiconductive layer 12 by, for example, metalization.

The conductive tubular member 11 is made of a material of high thermal and electric conductivity such as copper or platinum, or ceramic into which silicon carbide or carbon is dispersed to give electric conductivity. The n-type semiconductive layer 12 is made of an n-type semiconductive material such as bismuth telluride or lead telluride or an oxide, for example, sodium-cobalt oxide (NaCo$_2$O4). The conductive layer 13 is made of nickel or copper alloy.

The reference numeral 20 is a p-type member of a thermoelectric-conversion element 1. The p-type member 20 is the same as the n-type member 10 except that its semiconductive layer 22 is of a p-type semiconductive material.

The n-type and p-type members 10 and 20 of each thermoelectric-conversion element 1 are disposed in parallel with each other, and the n-type and p-type semiconductive layers 12 and 22 are connected by a connector 2 through the conductive layers 13 and 23. The connector 2 is made of a material of high electric conductivity such as copper or platinum, or a heat-resisting material such as chromium or molybdenum alloy.

Accordingly, when hot or cold fluid is run through the channels 11h and 21h in the conductive tubular members 11 and 21 of each thermoelectric-conversion element 1, the conductive tubular members 11 and 21 are heated or cooled; accordingly, potential difference occurs between the hot junctions and cold junctions in accordance with the temperature difference between the hot junctions and cold junctions. Thus, electric power can be extracted from each thermoelectric-conversion element 1.

Because heating or cooling fluid flows through the channels 11h and 21h in the conductive tubular members 11 and 21 of the thermoelectric-conversion element 1, the conductive tubular members 11 and 21 are heated or cooled efficiently, creating large temperature difference between the hot junctions and cold junctions. Accordingly, the generating capacity of thermoelectric-conversion element 1 is large.

For example, if the outer surface of the thermoelectric-conversion element 1 is put in contact with a wall surface of an industrial furnace or an engine housing or the like and cooling water is run through the channels 11h and 21h, large temperature difference between the hot and cold junctions can be achieved. Thus, a large generating capacity can be achieved.

If a material, generating heat is a liquid or gas, the material may be run along the outside of the thermoelectric-conversion element 1 to heat the outside or the material may be run through the channels 11h and 21h to heat the inside of the thermoelectric-conversion element 1. In either case, large temperature difference between the hot and cold junctions can be achieved. Thus, a large generating capacity can be achieved.

If the n-type and p-type members 10 and 20 of the thermoelectric-conversion element 1 are made longer, the areas of outsides of conductive tubular members 11 and 21 and the areas of the conductive layers 13 and 23 become larger; accordingly, a large electric current is obtained. If the areas of outsides of conductive tubular members 11 and 21 and the areas of the conductive layers 13 and 23 are large enough, the electric resistance does not increase if the n-type and p-type semiconductive layers 12 and 22 are made thin. Thus, because the paths of electricity through the n-type and p-type semiconductive layers 12 and 13 can be made short without increasing the electric resistance, the generating capacity of the thermoelectric-conversion element 1 can be further increased. If the n-type and p-type semiconductive layers 12 and 22 are made thin, their strength is reduced. However, the conductive tubular members 11 and 21 bear the force working on the n-type and p-type semiconductive layers 12 and 22. Therefore, if the n-type and p-type semiconductive layers 12 and 22 are exposed to external force, they will not be damaged easily. Thus, the strength of the thermoelectric-conversion element 1 is large.

The conductive layers 13 and 23 are dispensable. However, if they are provided, they can be designed so that they will bear the force working on the n-type and p-type semiconductive layers 12 and 22. Besides, if they are provided, electricity flows through the n-type and p-type semiconductive layers 12 and 22 in directions perpendicular to the longitudinal center axes of the conductive tubular members 11 and 21. Thus, the paths of electricity through the n-type and p-type semiconductive layers 12 and 13 are short and, hence, the generating efficiency of the thermoelectric-conversion element 1 is high. When the two thermoelectric-conversion elements 1 and 1 are connected by a conductor 5 as show in Figs. 1 and 2, electricity flows through the n-type and p-type semiconductive layers 12 and 22 in radial directions to and from the conductive layers 13 and 23 and the conductor 5; therefore, the electric resistance between the semiconductive layers 12 and 22 and the conductor 5 is relatively small.

As shown in Figs. 1 and 2, the conductor 5 made of a material of high electric conductivity such as copper or platinum connects the conductive tubular member 21 of the p-type member 20 of a thermoelectric-conversion element 1 and the conductive tubular member 11 of the n-type member 10 of the other thermoelectric-conversion element 1. Thus, the two thermoelectric-conversion elements 1 and 1 of the thermoelectric-conversion module "M" are connected in series. By connecting several thermoelectric-conversion elements 1 in series to make a module, several times the electric power of a single thermoelectric-conversion element 1 can be obtained.

The conductive tubular members 11 and 21 of each thermoelectric-conversion element 1 of the thermoelectric-conversion module "M" of Figs. 1 and 2 may be connected by a connector 2. In this case, the p-type semiconductive layer 22 of a thermoelectric-conversion element 1 and the n-type semiconductive layer 12 of the other thermoelectric-conversion element 1 are connected by a conductor 5. Thus, a thermoelectric-conversion module "M" consisting of two thermoelectric-conversion elements 1 and 1 connected in series is made.

The cross section of each of the conductive tubular members 11 and 22 of the thermoelectric-conversion element 1 may be square, hexagonal or in any other shape. Besides, the conductive tubular members 11 and 21 and the channels 11h and 21h may be bent as long as fluid can be run through the channels 11h and 21h.

Moreover, the n-type and p-type members 10 and 20 of the thermoelectric-conversion element 1 may be disposed not in parallel with each other, but at an angle with each other as long as the conductive tubular members 11 and 21 are electrically connected or the n-type and p-type semiconductive layers 12 and 22 are electrically connected.

Furthermore, although the connectors 2 shown in Figs. 1 and 2 are in the shape of a plate, they may be in any shapes as long as they can connect the n-type members 10 and the p-type members 20 electrically.

If conductive layers 13 and 23 are provided on the n-type and p-type semiconductive layers 12 and 22 of the thermoelectric-conversion element 1, the conductive layers 13 and 23 may be connected by the connector 2.

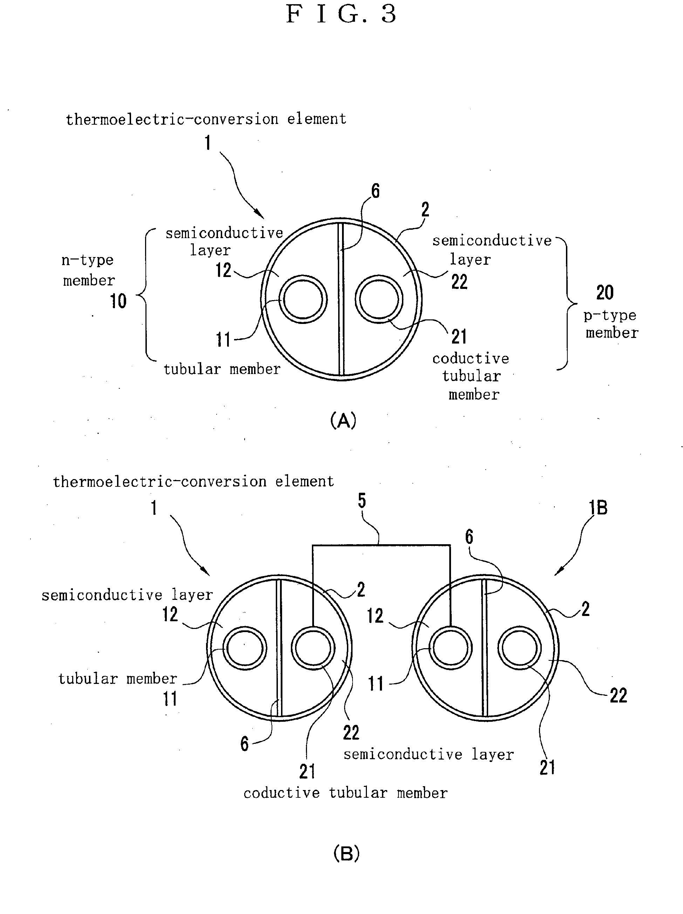

Fig. 3 (A) shows another embodiment 1 of thermoelectric-conversion element of the present invention. The thermoelectric-conversion element 1 comprises an n-type member 10 and a p-type member 20. The n-type member 10 includes a conductive tubular member 11 and an n-type semiconductive layer 12, and the p-type member 20 includes a conductive tubular member 21 and a p-type semiconductive layer 22. The n-type and p-type members 10 and 20 and an insulating layer 6 therebetween are brought together to form a single unit, and a connector 2 is formed on the outside of the single unit. Then, as shown in Fig. 3 (B), the conductive tubular member 21 of the p-type member 20 of a thermoelectric-conversion element 1 and the conductive tubular member 11 of the n-type member 10 of another thermoelectric-conversion element 1 are connected by a conductor 5 to form a thermoelectric-conversion module "M."

The connector 2 may be formed by metalization.

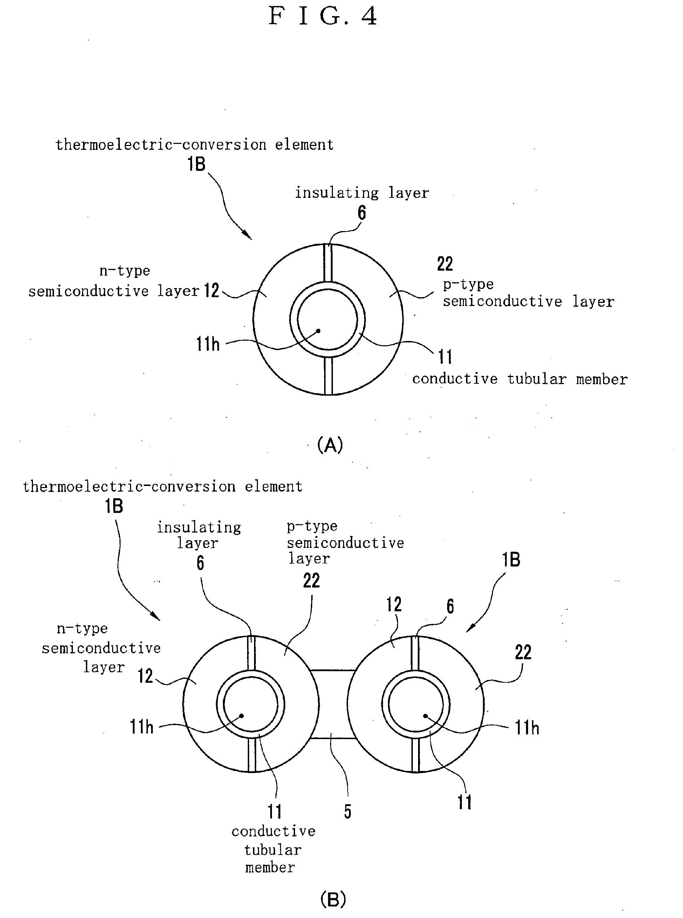

Fig. 4 (A) shows still another embodiment 1B of thermoelectric-conversion element of the present invention. The thermoelectric-conversion element 1B comprises a single conductive tubular member 11 made of a material of high thermal and electric conductivity, an n-type semiconductive layer 12, a p-type semiconductive layer 22, and two insulating layers 6 and 6. Formed in the conductive tubular member 11 is a channel through which hot or cold fluid is run. The n-type and p-type semiconductive layers 12 and 22 are formed in parallel with each other, along the longitudinal axis of the conductive tubular member 11, on the outside of the conductive tubular member 11. The two insulating layers 6 and 6 are put between the n-type and p-type semiconductive layers 12 and 22 to prevent them from coning into direct electric contact with each other.

Accordingly, the n-type and p-type semiconductive layers 12 and 22 are not in direct electric contact with each other, but are connected by or through the single conductive tubular member 11. When hot or cold fluid is run through the channel 11h, potential difference occurs between the hot and cold junctions in accordance with the temperature difference between the hot and cold conjunctions.

The insulating layers 6 and 6 are dispensable, but if they are provided, the vanishment of electrons and holes at the contact surfaces between the n-type and p-type semiconductive layers 12 and 22 is prevented; accordingly, the electricity-generating efficiency of the thermoelectric-conversion element 1 B is high.

Then, as shown in Fig. 4 (B), the p-type semiconductive layer 22of a thermoelectric-conversion element 1B and the n-type semiconductive layer 12 of another thermoelectric-conversion element 1B are connected by a conductor 5 to form a thermoelectric-conversion module "M."

Next, the method of making the thermoelectric-conversion element 1 will be described.

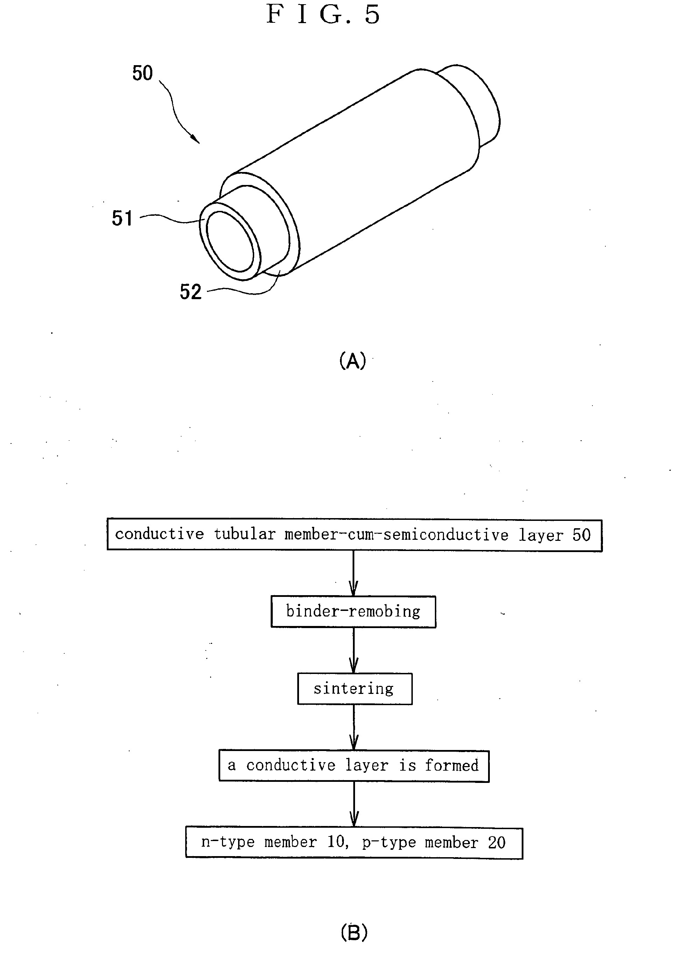

Fig. 5 (A) is an illustration of a conductive tubular member-cum-semiconductive layer 50 in process. Fig. 5 (B) is a flowchart of making the n-type and p-type members of Figs. 1 and 2 out of the conductive tubular member-cum-semiconductive layer 50 in process of Fig. 5 (A).

As shown in Fig. 5 (A), the conductive tubular member-cum-semiconductive layer 50 in process includes (i) a conductive tubular member 51 of a material of high thermal and electric conductivity, such as platinum, and (ii) a semiconductive layer 52 formed out of a semiconductive material "m" consisting of an n-type or p-type semiconductive material and an organic binder. The semiconductive layer 52 is formed on the outside of the conductive tubular member 51 by extrusion. The extrusion will be described later.

As shown in Fig. 5 (B), the conductive tubular member-cum-semiconductive layer 50 is first heated to 400°C to 600°C to vaporize and remove the organic binder contained in the semiconductive layer 52 (binder-removing step). Next, the conductive tubular member-cum-semiconductive layer 50 is sintered at 1,000°C to 1,100°C (sintering step). Then, a conductive layer is formed on the outside of the semiconductive layer 52 by metalization or the like. Thus, n-type and p-type members 10 and 20 are made.

As described above, the conductive tubular member 51 and the semiconductive layer 52 can be made as a single unit just by extruding and sintering, requiring no particular step of joining them together. Thus, the number of steps of the process of making the thermoelectric-conversion element 1 is held down.

The conductive tubular member 51 may be made of a metal, such as, platinum, tungsten, molybdenum, nickel, or stainless steel, which is not oxidized at the temperature of sintering and whose thermal and electric conductivity is not affected by the sintering, or a nonmetallic material with high thermal and electric conductivity such as silicon carbide. The semiconductive material "m" may contain a water-soluble binder such as methyl cellulose instead of an organic binder. If the semiconductive material "m" contains a water-soluble binder, the semiconductive layer 52 is dried and, then, heated to remove the binder and sintered as described above.

Next, the method of making the conductive tubular member-cum-semiconductive layer 50 will be described below.

Oxides such as $NaCo_2O_4$ is suitable as materials of n-type and p-type semiconductive layers 12 and 22 of n-type and p-type members 10 and 20 of the thermoelectric-conversion element 1 because of their high Seebeck effect. On the other hand, such oxides are ceramic powder; therefore, it is difficult to form such oxides into desired shapes. By using the following method, however, the semiconductive layer 52 can be formed out of such oxides.

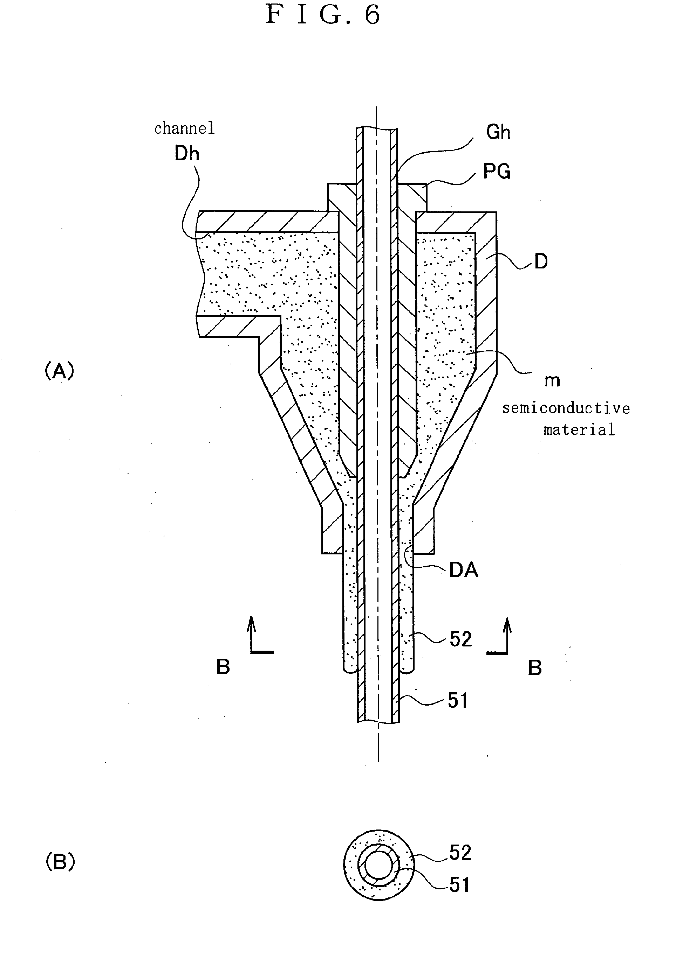

Fig. 6 is a schematic illustration of a die to form the conductive tubular member-cum-semiconductive layer 50. The reference sign "D" is a die wherein the fluid semiconductive material "m" flows. Formed in the die "D" is a channel "Dh" through which the semiconductive material "m" flows. The reference sign "DA" is an exit.

The reference numeral "PG" is a conductive-tubular-member guide, whose bottom is inside the die "D" and whose top is outside of the die "D." The conductive-tubular-member guide "PG" has a through hole "Gh." The conductive tubular member 51 is inserted into the through hole "Gh," its bottom protruding out of the exit "DA."

Accordingly, when the semiconductive material "m," together with the conductive tubular member 51, is extruded from the exit "DA" of the die "D," the semiconductive layer 52 is formed on the outside of the conductive tubular member 51 as shown in Fig. 6 (B).

Because the semiconductive layer 52 is formed on the outer surface of the conductive tubular member 51, the former is supported by the latter. Accordingly, the semiconductive layer 52 is prevented from breaking while it is being formed. Besides, if it is relatively thin, it is prevented from breaking. Thus, the n-type and p-type members 10 and 20 are made efficiently.

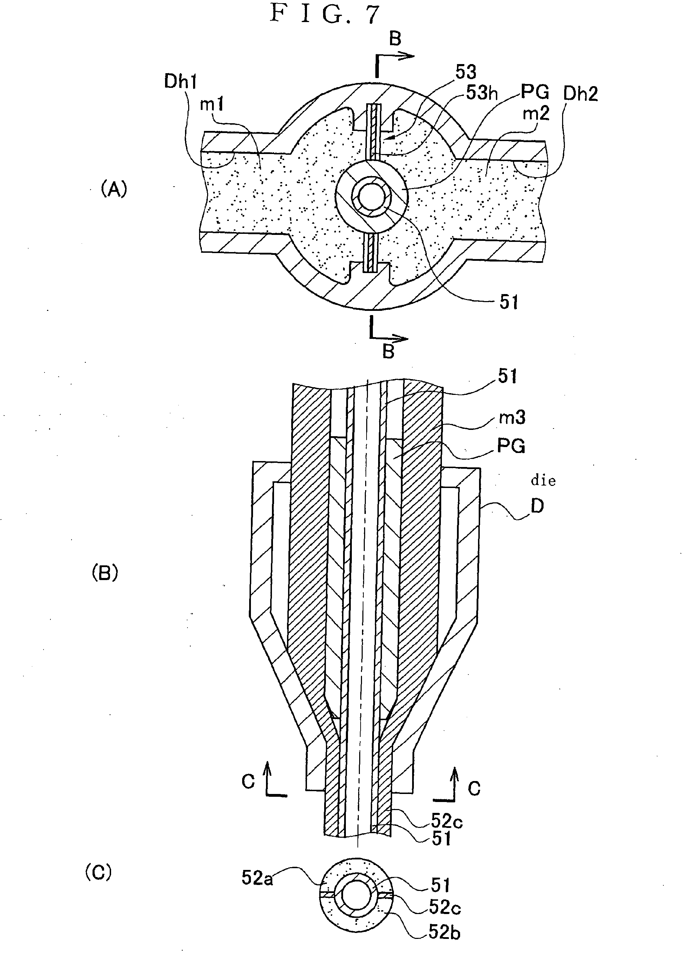

Fig. 7 shows a die to make thermoelectric-conversion element 1B of Fig. 4.

In Fig. 7, the reference signs "D," "DA," "PG," "Dh1," and "Dh2" are a die, an exit of the die, a conductive-tubular-member guide, a channel for n-type semiconductive material "m1," and a channel for p-type semiconductive material "m2," respectively. As shown in Fig. 7 (A), disposed between the inside of the die "D" and the outside of the conductive-tubular-member guide "PG" are two pairs of partitions 53 to make the two channels "Dh1" and "Dh2" out of one in the die "D." The gap between the partitions of each pair is a channel "53h" for insulating material "m3." The bottoms of the partitions 53 are disposed in the vicinity of the exit "DA." Thus, the two channels "Dh1" and "Dh2" join at the bottoms of the partitions 53.

Accordingly, when the n-type semiconductive material "m1," p-type semiconductive material "m2," and insulating material "m3," together with the conductive tubular member 51, are extruded from the exit "DA," a p-type semiconductive layer 52a, an n-type semiconductive layer 52b, and two insulating layer 52c are formed, each insulating layer 52c caught between the p-type and n-type semiconductive layers 52a and 52b, as shown in Fig. 7 (C).

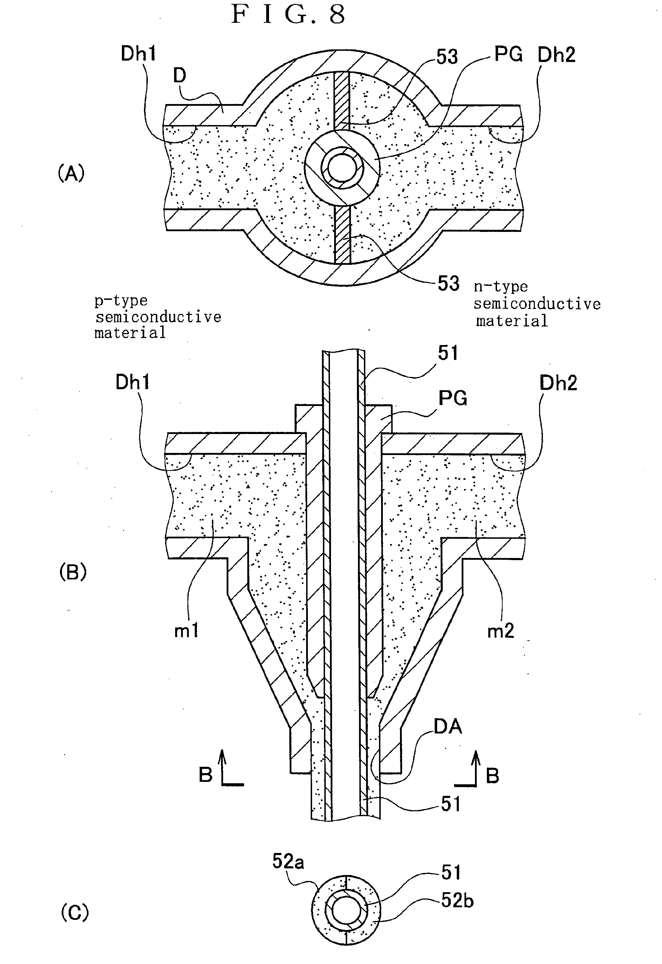

As mentioned earlier, the insulating layers 52c are dispensable; therefore, the channels "53h" for insulating material "m3" are dispensable, as shown in Fig. 8.

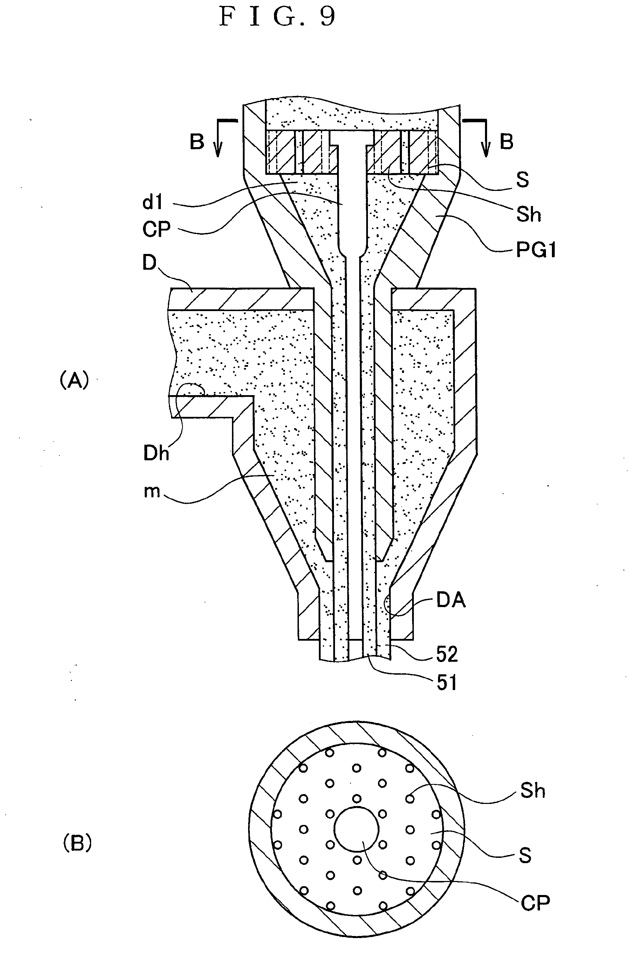

Fig. 9 shows a die "D" to form both the conductive tubular member 51 and the semiconductive layer 52 simultaneously. The die "D" of Fig. 9 is the same as the die "D" of Fig. 6 except that the latter die "D" has the conductive-tubular-member guide "PG," whereas the former die "D" has a conductive-tubular-member die "PG1."

As shown in Fig. 9 (A), the conductive-tubular-member die "PG1" has a channel-forming member "CP," the channel being the channel 11h or 21h shown in Fig. 2. The bottom of the channel-forming member "CP" is disposed at the bottom of the exit "DA."

Accordingly, when a conductive material "d1" is extruded through the gap around the channel-forming member "CP" in the conductive-tubular-member die "PG1" and a semiconductive material "m" is extruded through the channel "Dh" of the die "D" simultaneously, the conductive tubular member 51 and the semiconductive layer 52 are formed simultaneously.

Besides, both the conductive tubular member 51 and the semiconductive layer 52 are formed out of fluid materials, the conductive tubular member-cum-semiconductive layer 50 can be given various shapes. Thus, the thermoelectric-conversion element 1 can be given various shapes. If the conductive tubular member-cum-semiconductive layer 50 is bent before it solidifies and, then, sintered, curved n-type and p-type members 10 and 20 can be made.

Moreover, a baffle member "S" may be provided as a support to hold the channel-forming member "CP" in the conductive-tubular-member die "PG1." If vertical through holes are made evenly in the baffle member "S," the conductive material "d1" flows evenly through the conductive-tubular-member die "PG1"; therefore, homogeneous conductive tubular members 51 are made.

If the sintering temperature of the conductive material "d1" is about the same as that of the semiconductive material "m," the conductive tubular member 51 and the semiconductive layer 52 can be sintered almost simultaneously.

Industrial Applicability

The thermoelectric-conversion element of the present invention makes use of Seebeck effect to generate electricity by converting heat from various heat sources, such as walls of industrial furnaces, engine housings, industrial cooling water, cooling waters of engines, exhaust gas from chimneys and engines, etc., into electricity.

**Claims**

**1.** A thermoelectric-conversion element comprising:

an n-type member which includes a conductive tubular member having a channel in it and an n-type semiconductive layer formed on the outside of the conductive tubular member;

a p-type member which includes a conductive tubular member having a channel in it and a p-type semiconductive layer formed on the outside of the conductive tubular member; and

a connector which electrically connects the conductive tubular member of the n-type member and the conductive tubular member of the p-type member.

2. A thermoelectric-conversion module comprising a plurality of thermoelectric-conversion elements according to claim 1 connected in series, the n-type and p-type semiconductive layers of each thermoelectric-conversion element being connected to the p-type semiconductive layer of another thermoelectric-conversion element and the n-type semiconductive layer of yet another thermoelectric-conversion element, respectively.

3. A thermoelectric-conversion element comprising:

an n-type member which includes a conductive tubular member having a channel in it and an n-type semiconductive layer formed on the outside of the conductive tubular member;

a p-type member which includes a conductive tubular member having a channel in it and a p-type semiconductive layer formed on the outside of the conductive tubular member; and

a connector which electrically connects the n-type semiconductive layer and the p-type semiconductive layer.

4. A thermoelectric-conversion module comprising a plurality of thermoelectric-conversion elements according to claim 3 connected in series, the conductive tubular member of the n-type member and the conductive tubular member of the p-type member of each thermoelectric-conversion element being connected to the conductive tubular member of the p-type member of another thermoelectric-conversion element and the conductive tubular member of the n-type member of yet another thermoelectric-conversion element, respectively.

5. The thermoelectric-conversion element according to claim 1, 2, 3, or 4, wherein a conductive layer is formed on each of the n-type and p-type semiconductive layers.

6. A thermoelectric-conversion element comprising:

a conductive tubular member having a channel in it;

an n-type semiconductive layer formed on one half of the outer surface of the conductive tubular member when the outer surface is divided into two along the longitudinal center axis of the conductive tubular member; and

a p-type semiconductive layer formed on the other half of the outer surface of the conductive tubular member,

the n-type and p-type semiconductive layers being connected by the conductive tubular member.

7. A thermoelectric-conversion module comprising a plurality of thermoelectric-conversion elements according to claim 6 connected in series, the n-type and p-type semiconductive layers of each thermoelectric-conversion element being connected to the p-type semiconductive layer of another thermoelectric-conversion element and the n-type semiconductive layer of yet another thermoelectric-conversion element, respectively.

8. A method of manufacturing a thermoelectric-conversion element, comprising the steps of:

forming an n-type body including a conductive tubular member having a channel in it and an n-type semiconductive layer formed on the outside of the conductive tubular member and a p-type body including a conductive tubular member having a channel in it and a p-type semiconductive layer formed on the outside of the conductive tubular member;

sintering the n-type and p-type bodies; and

connecting the n-type and p-type bodies in series by a conductor.

9. The method according to claim 8, wherein a conductive layer is formed on the semiconductive layer of each of the sintered n-type and p-type bodies before the sintered n-type and p-type bodies are connected in series by the conductor.

10. The method according to claim 8 or 9, wherein each of the n-type and p-type bodies is formed by extruding a conductive tubular member and a fluid semiconductive material simultaneously from a single die.

11. The method according to claim 8 or 9, wherein each of the n-type and p-type bodies is formed by extruding a fluid conductive material and a fluid semiconductive material simultaneously from a single die.

# F I G. 1

thermoelectric-conversion module

thermoelectric-conversion element

n-type member 10

connector 2

p-type member 20

conductive tubular member 11

semiconductive layer 12

M

1

1

13

10

2

20

5

23

conductor

11 12 13

21 22 23

22

semiconductive layer

21

conductive tubular member

D

# FIG. 2

thermoelectric-conversion element

thermoelectric-conversion
module

1

n-type member    connector    p-type member
10              2            20          21h        2

M

13                          23 13              23

11h

semiconductive
layer

12

11

conductive
tubular
member

21

conductive
tubular
member

11  12    21 22

22

semiconductive
layer

5

conductor

D

# F I G. 3

thermoelectric-conversion element

1

6

2

semiconductive layer

n-type member

10

12

semiconductive layer

22

20

p-type member

11

tubular member

21

coductive tubular member

(A)

thermoelectric-conversion element

1

5

6

1B

semiconductive layer

12

2

12

2

tubular member

11

11

22

6

22

semiconductive layer

21

21

coductive tubular member

(B)

# F I G. 4

thermoelectric-conversion element

**1B**

insulating layer

**6**

n-type
semiconductive layer **12**

**22**
p-type
semiconductive layer

**11h**

**11**

conductive tubular member

(A)

thermoelectric-conversion element

**1B**

insulating
layer
**6**

p-type
semiconductive
layer
**22**

**1B**

**12**  **6**

n-type
semiconductive
layer  **12**

**22**

**11h**

**11h**

**11**  **5**  **11**

conductive
tubular
member

(B)

# F I G. 5

50

51

52

(A)

| conductive tubular member-cum-semiconductive layer 50 |
|---|

↓

| binder-remobing |
|---|

↓

| sintering |
|---|

↓

| a conductive layer is formed |
|---|

↓

| n-type member 10, p-type member 20 |
|---|

(B)

# F I G. 6

(A)

channel
Dh

Gh

PG

D

m

semiconductive
material

DA

52

B

B

51

(B)

52

51

# F I G. 7

(A)

(B)

(C)

# F I G . 8

(A)

Dh1 D    53 PG Dh2

p-type
semiconductive
material

53 n-type
semiconductive
material

(B)

Dh1    51

PG

Dh2

m1    m2

DA

B    B

51

52a    51

(C)    52b

# FIG. 9

(A)

(B)

# FIG.10

100
101
107
101
107

(A)

104
101
105
106
p n p n
n p n p
102 103
104

(B)

105
107
103
102
104
110
n p n p
104
106

(C)

# FIG.11

(A)

(B)

## INTERNATIONAL SEARCH REPORT

| International application No. |
| --- |
| PCT/JP03/10182 |

**A. CLASSIFICATION OF SUBJECT MATTER**
Int.Cl⁷ H01L35/32, H01L35/30, H01L35/34

According to International Patent Classification (IPC) or to both national classification and IPC

**B. FIELDS SEARCHED**

Minimum documentation searched (classification system followed by classification symbols)
Int.Cl⁷ H01L35/32, H01L35/30, H01L35/34

Documentation searched other than minimum documentation to the extent that such documents are included in the fields searched

| | | | |
| --- | --- | --- | --- |
| Jitsuyo Shinan Koho | 1922-1996 | Toroku Jitsuyo Shinan Koho | 1994-2003 |
| Kokai Jitsuyo Shinan Koho | 1971-2003 | Jitsuyo Shinan Toroku Koho | 1996-2003 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2000-294840 A (Yamaha Corp.), 20 October, 2000 (20.10.00), Full text; Figs. 1 to 8 (Family: none) | 1-11 |
| A | JP 2002-238272 A (Tokyo Gas Co., Ltd.), 23 August, 2002 (23.08.02), Full text; Figs. 1 to 19 (Family: none) | 1-7 |
| A | JP 2002-136161 A (Tokyo Gas Co., Ltd.), 10 May, 2002 (10.05.02), Full text; Figs. 1 to 15 (Family: none) | 1-7 |

☒ Further documents are listed in the continuation of Box C.    ☐ See patent family annex.

| | |
| --- | --- |
| *    Special categories of cited documents:<br>"A"  document defining the general state of the art which is not considered to be of particular relevance<br>"E"  earlier document but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |
| Date of the actual completion of the international search<br>06 November, 2003 (06.11.03) | Date of mailing of the international search report<br>18 November, 2003 (18.11.03) |
| Name and mailing address of the ISA/<br>Japanese Patent Office | Authorized officer |
| Facsimile No. | Telephone No. |

Form PCT/ISA/210 (second sheet) (July 1998)

21

### INTERNATIONAL SEARCH REPORT

| International application No. |
|---|
| PCT/JP03/10182 |

**C (Continuation). DOCUMENTS CONSIDERED TO BE RELEVANT**

| Category* | Citation of document, with indication, where appropriate, of the relevant passages | Relevant to claim No. |
|---|---|---|
| A | JP 2000-018095 A (Nissan Motor Co., Ltd.), 18 January, 2000 (18.01.00), Full text; Figs. 1 to 18 (Family: none) | 1-7 |
| A | JP 2003-163385 A (Matsushita Electric Works, Ltd.), 06 June, 2003 (06.06.03), Full text; Figs. 1 to 26 (Family: none) | 8-11 |
| A | JP 2002-111085 A (Komatsu Ltd.), 12 April, 2002 (12.04.02), Full text; Figs. 1 to 9 (Family: none) | 8-11 |
| A | JP 10-242536 A (Matsushita Electric Works, Ltd.), 11 September, 1998 (11.09.98), Full text; Figs. 1 to 10 (Family: none) | 8-11 |

Form PCT/ISA/210 (continuation of second sheet) (July 1998)